(19)

**Europäisches Patentamt**

**European Patent Office**

**Office européen des brevets**

(11)     **EP 3 893 009 B1**

(12)                         **EUROPEAN PATENT SPECIFICATION**

(45) Date of publication and mention
of the grant of the patent:
**25.10.2023   Bulletin 2023/43**

(21) Application number: **20208980.1**

(22) Date of filing: **20.11.2020**

(51) International Patent Classification (IPC):
**G01R 31/319** *(2006.01)*

(52) Cooperative Patent Classification (CPC):
**G01R 31/31926**

(54) **APPARATUS FOR DETECTING INVALID CONFIGURATIONS IN BI-DIRECTIONAL MULTIPLEXING CIRCUITS**

VORRICHTUNG ZUR ERKENNUNG UNGÜLTIGER KONFIGURATIONEN IN BI-DIREKTIONALEN MULTIPLEX-SCHALTUNGEN

APPAREIL DE DÉTECTION DES CONFIGURATIONS NON VALIDES DANS LES CIRCUITS MULTIPLEXEURS BI-DIRECTIONNELS

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **07.04.2020   EP 20168524**

(43) Date of publication of application:
**13.10.2021   Bulletin 2021/41**

(73) Proprietor: **Shenzhen Goodix Technology Co., Ltd. Shenzhen, Guangdong 518045 (CN)**

(72) Inventor: **Jakschik, Daniel**
**01157 Dresden (DE)**

(74) Representative: **Lippert Stachow Patentanwälte Rechtsanwälte**
**Partnerschaft mbB**
**Krenkelstraße 3**
**01309 Dresden (DE)**

(56) References cited:
**EP-A2- 1 426 780     JP-A- 2000 147 069**
**US-A- 6 145 104     US-A1- 2004 111 657**

**Description**

The invention relates to an apparatus for detecting invalid configurations in bi-directional multiplexing infrastructures.

A multiplexer is a circuitry which selectively drives an output signal Z from different sources A, B, C, ... depending on a control signal SZ. The number of inputs N defines the width W of the control signal SZ by

$$W = \lceil log_2(N) \rceil \text{ (eq.1).}$$

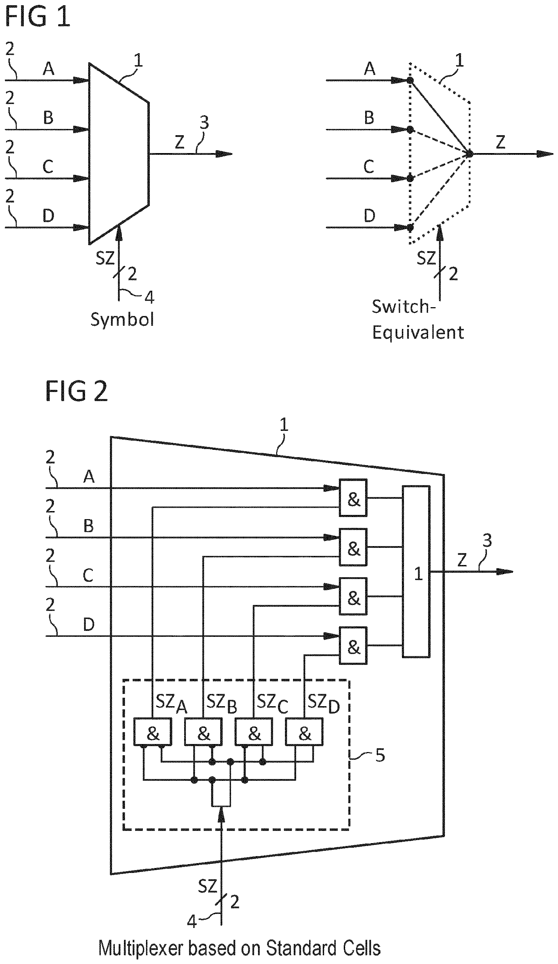

Figure 1 shows the symbol of a multiplexer and a simplified circuitry. The output Z is driven by input A as soon as the control signal SZ is 0; input B is forwarded as soon as SZ becomes 1, and so on. The number of N identifies the size of the multiplexer. The example multiplexer 1 of figure 1 has four inputs 2 and is there with a 4:1 multiplexer. The width of the data signals Z, A, B, C ... is always identical; here they have the width 1. But any data width is supported.

Multiplexer can be used as switching elements, see for example EP 1 426 780 A2 and US 2004/0111657 A1.

Internally the multiplexer 1 is realized by two parts, the data path as one part and the control part 5 as another part, as shown in figure 2.

The output Z is created by OR'ing all sources, which are gated by an AND-gate. Just one of the AND-gates gets a highlevel on its second input and therewith just one multiplexer input passes.

The control part 5 generates the secondary AND-gate input signals. A one-hot decoder creates a high signal depending on the control signal SZ. The following formulas specify the exact logic conditions:

$$SZ_A = !SZ[1] \And !SZ[0] \qquad (eq.2)$$

$$SZ_B = !SZ[1] \And SZ[0] \qquad (eq.3)$$

$$SZ_C = SZ[1] \And !SZ[0] \qquad (eq.4)$$

$$SZ_D = SZ[1] \And SZ[0] \qquad (eq.5)$$

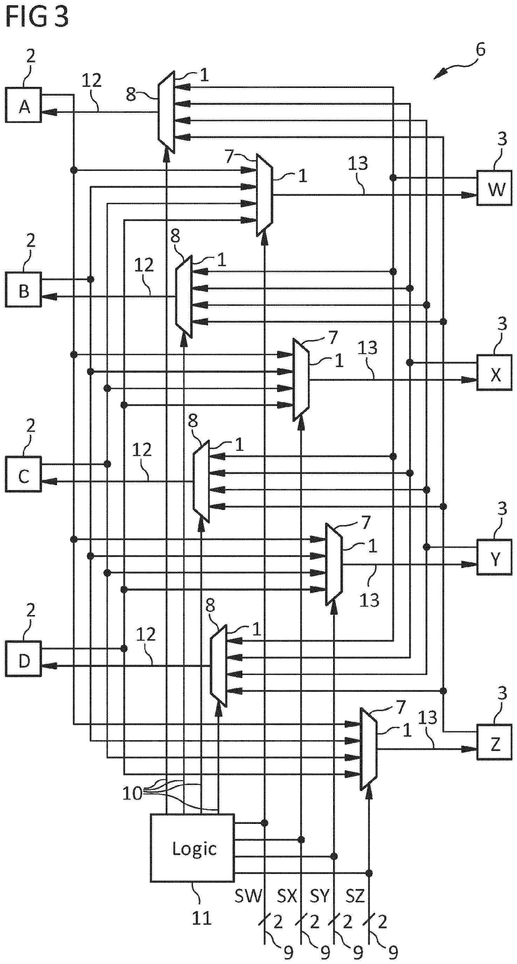

In more complex application scenarios multiple sources A, B, C and D and multiple sinks W, X, Y and Z need to be connected to each other. The data flows from source to sink. The sinks also send data back to the sources. The forward signals (from source to sink) might have a width and the backward signals (from sink to source) might have another width. At the end there are two types of signals. The forward and the backward one. It is also possible to split the one forward signal with a width of i. e. 16 bit into two 8 bit signals. Backward signal can be split too. Figure 3 shows an example of a bi-directional multiplexer 6. All sources A, B, C and D 2 can be muxed to all sinks W, X, Y and Z 3. The forward multiplexers 7 are steered by the control signals SW, SX, SY and SZ 9. The backward direction multiplexer control can be derived from SW, SX, SY and SZ 9. Due to the fact, that there are four sinks and four sources in the example of figure 3, the width of the control signals $Sm_n$ is two. It is good to present the forward control signals SW, SX, SY and SZ to the end-user, as they are easy to understand, if the basic principle of a multiplexer is understood.

Problem of such generic bi-directional multiplexing infrastructures are invalid configurations. If a sink (i. e. W) is already driven by a source (i. e. A), the other sinks (i. e. X) are not allowed to select this allocated source (here A). It is possible to select them by the control signals, but the resulting configuration is invalid.

It is therefore an object of the present invention to disclose a circuitry that detects such invalid configurations.

The object will be solved by an apparatus for detecting invalid configurations in a bi-directional multiplexing infrastructure according to independent claim 1. The inventive apparatus that comprises the infrastructure, which comprises a multiplexer decoder logic configured to process control signals, multiple sources as inputs and multiple sinks as outputs, whereas the sources and sinks are connected via forward and backward multiplexers, wherein the multiplexer decoder logic is extended by a configuration error checker which monitors each source and all control signals of the backward multiplexers connected to the sources and creates error information which source is used more than once.

The configuration error detector is configured to detect invalid configurations. The multiplexer decoder logic is configured to generate the backward multiplexer control signals $Sm_n$, where m stands for the sink identifier and n stands for the source identifier.

The configuration error detector can be applied on bi-directional multiplexing infrastructures with any number of sources N and any number of sinks M and gives detailed information on the configuration error. M and N are positive natural number greater than 0. It eases debugging and configuration of complex bi-directional multiplexers with larger numbers of N and M. The configuration error detector evaluates all backward multiplexer control signals and creates error information which source is used more than once. The backward signals for instance might signal if the next data can be accepted or a pause needs to be inserted. The multiplexer configuration is invalid as soon as more than one multiplexer selects the corresponding source.

According to the invention, the configuration error checker comprises an evaluation instance for each source n, whereas each evaluation instance outputs a logical equivalent $E_n$ to the control signals of the backward multiplexers for one source n.

This can be expressed also by

$$E_n = \begin{cases} 1 & \sum_m Sm_n > 1 \\ 0 & \sum_m Sm_n <= 1 \end{cases} \quad (\text{eq.6})$$

indicating the error condition for a given source n. If $E_n$ is equal to zero than the control signal configuration for said source is valid, otherwise it is invalid.

The configuration error checker or an evaluation instance for a source is only needed, if a source has to handle backward signals. Sources without backward signals do not need any multiplexer configuration checking.

According to the invention, the evaluation instance for each source n comprises standard-cells with AND- and OR-gates. Hence the implementation of the inventive apparatus is very easy in chip design.

According to the invention, the logical equivalent $E_n$ for one source n is determined by connecting the control signals of two sinks for said source n by an AND- and by an OR-operation, the result of the OR-operation is combined with a control signal of a further sink for said source n by an AND- and by an OR-operation, whereas this is going on until the control signals of all sinks for said source n are processed such and finally all outputs of the processed AND-operations are connected by a final OR-operation.

As described above, the determination of the logical equivalent $E_n$ is realized by standard-cells. The multiplexer decoder logic generates the internal control signals $Sm_n$ for the backward multiplexers, whereas each sink m contributes a control signal $Sm_n$ to a source n of the bi-directional multiplexing infrastructure if said source n can be reached by backward signals. These control signals are further processed by the evaluation instance for each source in order to determine the logical equivalent $E_n$ for each source n and to evaluate if said source n is only used once, otherwise the configuration would be invalid, as it is not allowed to select an already allocated source more than once.

So, according to a variant of the inventive apparatus, if the logical equivalent $E_n$ for one source is zero than a control signal configuration for said source is valid, otherwise it is invalid.

The bi-directional multiplexing infrastructure is invalid as soon as more than one multiplexer selects the corresponding source. Pursuant to a further variant of the invention, if a sum E over all logical equivalents $E_n$ for all sources n is equal to zero the entire bi- directional multiplexing infrastructure is valid, otherwise it is invalid.

This can be expressed also by

$$E = \begin{cases} 1 & \sum_n E_n > 1 \\ 0 & \sum_n E_n = 1 \end{cases} \quad (\text{eq.7})$$

calculating if the entire bi-directional multiplexing infrastructure is valid or not. If the sum E is equal to zero than the entire bi-directional multiplexing infrastructure is valid, otherwise it is invalid.

In a variant of the invention, the number N of sources is equal or greater than two and in another variant the number M of sinks is equal or greater than two. The inventive apparatus works for any bi-directional multiplexer complexity, hence of any number of sources N and sinks M.

Besides that, a width of the multiplexed data signals is independent to the configuration error checker and can be any positive number.

The inventive apparatus works for any bi-directional multiplexer complexity. For any number of sources N and sinks M.

The invention will be explained in more detail using an exemplary embodiment.

The appended drawings show

Fig. 1    Multiplexer;

Fig. 2    Multiplexer based on standard cells;

Fig. 3    Bi-directional multiplexing;

Fig. 4    Bi-directional multiplexer infrastructure with configuration error checker according to the invention (for sources A and B).

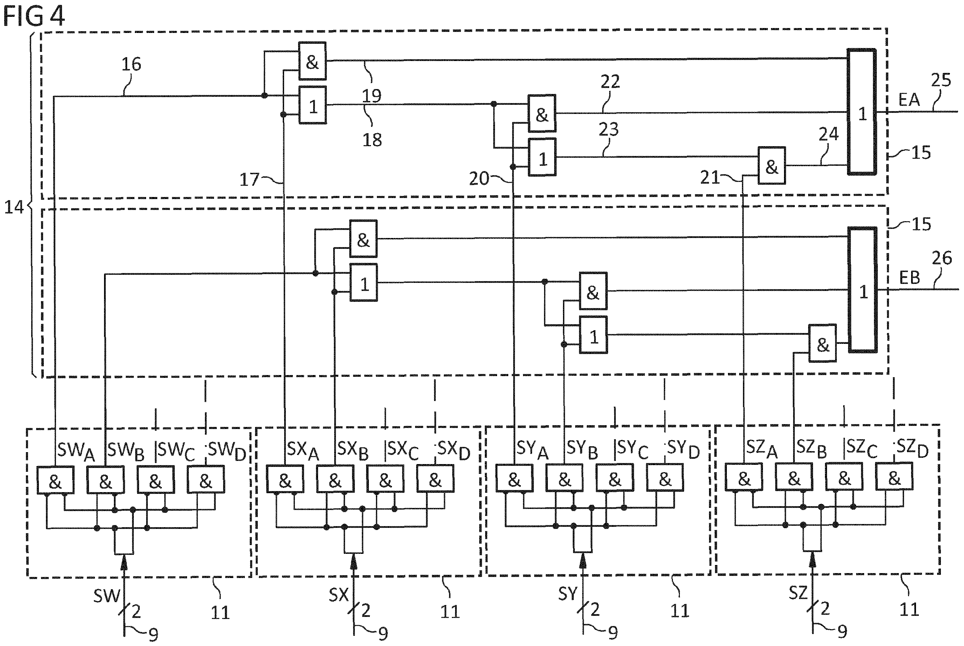

Figure 4 shows the inventive apparatus which can be seen as an extension to the multiplexer decoder logic 11 as the configuration error checker 14 uses the generated internal control signals $Sm_n$ for the backward multiplexers for evaluating if an error condition is fulfilled or not, hence if $E_n$ is equal to zero or one. Figure 4 does not show the whole bi-directional multiplexer infrastructure.

The configuration error checker circuitry 14 based on standard-cells. The lower part in figure 4 contains the multiplexer decoder logic 11 which generates the multiplexer internal control signals $Sm_n$. The upper part contains two evaluation instances 15 of the configuration error checker 14 for the sources A and B. The circuitry can be repeated for all other source (i. e. C and D).

In the following, the determination of the logical equivalent $E_n$, with n = source A, is described as an example. Firstly, the generated internal control signals $SW_A$ 16 and $SX_A$ 17 of the sinks W and X for source A are connected by an AND- and by an OR-operation, resulting in an output signal 19 of the AND-operation and an output signal 18 of the OR-operation. The result of the OR-operation, signal 18, is combined with the control signal $SY_A$ 20 of the further sink Y for source A by an AND- and by an OR-operation, resulting in a further output signal of the second OR-operation, signal 23, which is combined by an AND-operation with a third control signal $SZ_A$ 21 of sink Z for source A, resulting in an output signal 24. The second AND-operation of signal 18 and 29 result in an output signal 22. Finally, the outputs of the AND-operations, signals 19, 22 and 24 are ORing and output the logical equivalent $E_A$ 25 for source A. This determination of the logical equivalent for source A is based on figure 4 as an example for a multiplexer with four sources and four sinks.

One application of the present invention is the multiplexing of bi-directional pads on a chip. Every pad (sink) has multiple control signals, like output, output-enable, pullup control and so on and feeds back the pad input level to the digital logic inside the chip. The pad might be used for different purposes and therewith by different chip-internal blocks, i. e. UART, SPI, I2C. The chip-internal blocks (sources) can be muxed to multiple pads (sinks). The configuration error checker, hence the evaluation instance per pad eases the handling of complex setups.

**List** of Reference Signs

1 multiplexer
2 source, logical input
3 sink, logical output
4 control signal
5 control part
6 bi-directional multiplexer
7 forward multiplexer
8 backward multiplexer
9 control signal of the forward multiplexer, input to the multiplexer decoder logic
10 control signal of the backward multiplexer
11 multiplexer decoder logic
12 output of the backward multiplexer
13 output of the forward multiplexer
14 configuration error checker
15 evaluation instance of the configuration error checker
16 control signal of a first sink for a first source
17 control signal of a second sink for a first source
18 result of OR-operation between signal 16 and signal 17
19 result of AND-operation between signal 16 and signal 17
20 control signal of a third sink for a first source
21 control signal of a fourth sink for a first source
22 result of AND-operation between signal 18 and signal 20
23 result of OR-operation between signal 18 and signal 20
24 result of AND-operation between signal 23 and signal 21
25 logical equivalent for a first source

26 logical equivalent for a second source

## Claims

1. Apparatus for detecting invalid configurations in a bi-directional multiplexing infrastructure, wherein the apparatus comprises the bi-directional multiplexing infrastructure, wherein the bi-directional multiplexing infrastructure comprises a multiplexer decoder logic (11), multiple sources as inputs (2) and multiple sinks as outputs (3), wherein each source of the multiple sources (2) corresponds to a source n (2), wherein n stands for the source identifier, and wherein the sources (2) and sinks (3) are connected via forward (7) and backward multiplexers (8), **characterized in, that** the multiplexer decoder logic (11) further comprises a configuration error checker (14) configured to detect invalid configurations and to monitor each source n (2) and all control signals (10) of the backward multiplexers (8) connected to the sources (2), wherein the configuration error checker (14) comprises an evaluation instance (15) for each source n (2), wherein each evaluation instance (15) is configured to output a logical equivalent $E_n$ (25, 26) to the control signals (10) of the backward multiplexers (8) for one source n (2), wherein the logical equivalent $E_n$ (25, 26) for one source n (2) is determined by connecting the control signals of two sinks for said source n (2) by an AND and by an OR-operation via an AND- and an OR-gate, respectively, the result of the OR-operation is combined with a control signal of a further sink for said source n (2) by a further AND- and by a further OR-operation, wherein this step of combining the result of the OR-operation with a control signal of a further sink for said source n (2) by a further AND- and by a further OR-operation is repeated until the control signals of all sinks for said source n (2) are processed such and finally all outputs of the processed AND-operations are connected by a final OR-operation via a final OR-gate, and wherein the invalid configuration in the bi-directional multiplexing infrastructure is detected according to error information created by the configuration error checker (14) indicating which source n (2) is used more than once.

2. Apparatus for detecting invalid configurations in a bi-directional multiplexing infrastructure according to claim 1, wherein if the logical equivalent $E_n$ for one source n (2) is zero then a control signal configuration for said source n (2) is valid, otherwise it is invalid.

3. Apparatus for detecting invalid configurations in a bi-directional multiplexing infrastructure according to any of the former claims, wherein if a sum E over all logical equivalents $E_n$ for all sources (2) is equal to zero the entire bi-directional multiplexing infrastructure is valid, otherwise it is invalid.

4. Apparatus for detecting invalid configurations in a bi-directional multiplexing infrastructure according to any of the former claims, wherein the number of sources (2) is equal or greater than two.

5. Apparatus for detecting invalid configurations in a bi-directional multiplexing infrastructure according to any of the former claims, wherein the number of sinks (3) is equal or greater than two.

6. Apparatus for detecting invalid configurations in a bi-directional multiplexing infrastructure according to claim 1, wherein a width of the multiplexed data signals is independent to the configuration error checker (14) and can be any positive number.

## Patentansprüche

1. Vorrichtung zum Erkennen von ungültigen Konfigurationen in einer bidirektionalen Multiplexing-Infrastruktur, wobei die Vorrichtung die bidirektionale Multiplexing-Infrastruktur umfasst, wobei die bidirektionale Multiplexing-Infrastruktur eine Multiplexer-Decoder-Logik (11), mehrere Quellen als Eingänge (2) und mehrere Senken als Ausgänge (3) umfasst, wobei jede Quelle der mehreren Quellen (2) einer Quelle n (2) entspricht, wobei n für den Quellen-Identifikator steht, und wobei die Quellen (2) und Senken (3) über Vorwärts- (7) und Rückwärts-Multiplexer (8) verbunden sind, **dadurch gekennzeichnet, dass** die Multiplexer-Decoder-Logik (11) ferner einen Konfigurationsfehlerprüfer (14) umfasst, der dazu ausgelegt ist, ungültige Konfigurationen zu erkennen und jede Quelle n (2) und alle Steuersignale (10) der mit den Quellen (2) verbundenen Rückwärtsmultiplexer (8) zu überwachen, wobei der Konfigurationsfehlerprüfer (14) eine Auswertungsinstanz (15) für jede Quelle n (2) umfasst, wobei jede Auswertungsinstanz (15) dazu ausgelegt ist, ein logisches Äquivalent $E_n$ (25, 26) zu den Steuersignalen (10) der Rückwärtsmultiplexer (8) für eine Quelle n (2) auszugeben, wobei das logische Äquivalent $E_n$ (25, 26) für eine Quelle n (2) durch Verbinden der Steuersignale zweier Senken für die Quelle n (2) durch eine UND- und durch eine ODER-Operation über ein UND- bzw. ein ODER-Gatter bestimmt wird, das Ergebnis der ODER-Operation mit einem Steuersignal einer weiteren Senke für die Quelle n (2) durch eine weitere UND- und durch eine weitere ODER-Operation verknüpft wird, wobei dieser Schritt des Kombinierens des Ergebnisses der ODER-Operation mit einem Steuersignal einer weiteren Senke für die Quelle n (2) durch eine weitere UND- und durch eine weitere ODER-Operation wiederholt wird, bis die Steuersignale aller Senken für die Quelle n (2) so verarbeitet sind und schließlich alle Ausgänge der verarbeiteten UND-Operationen durch eine abschließende ODER-Operation über ein abschließendes ODER-Gatter verbunden sind, und wobei die ungültige Konfiguration in der bidirektionalen Multiplexing-Infrastruktur gemäß einer Fehlerinformation erkannt wird, die von dem Konfigurationsfehlerprüfer (14) erzeugt wird, der angibt, welche Quelle n (2) mehr als einmal verwendet wird.

2. Vorrichtung zum Erkennen ungültiger Konfigurationen in einer bidirektionalen Multiplexing-Infrastruktur nach Anspruch 1, wobei, wenn das logische Äquivalent $E_n$ für eine Quelle n (2) Null ist, eine Steuersignalkonfiguration für die Quelle n (2) gültig ist, andernfalls ist sie ungültig.

3. Vorrichtung zum Erkennen ungültiger Konfigurationen in einer bidirektionalen Multiplexing-Infrastruktur nach einem der vorhergehenden Ansprüche, wobei, wenn eine Summe E über alle logischen Äquivalente $E_n$ für alle Quellen (2) gleich null ist, die gesamte bidirektionale Multiplexing-Infrastruktur gültig ist, ansonsten ist sie ungültig.

4. Vorrichtung zum Erkennen ungültiger Konfigurationen in einer bidirektionalen Multiplexing-Infrastruktur nach einem der vorhergehenden Ansprüche, wobei die Anzahl der Quellen (2) gleich oder größer als zwei ist.

5. Vorrichtung zum Erkennen ungültiger Konfigurationen in einer bidirektionalen Multiplexing-Infrastruktur nach einem der vorhergehenden Ansprüche, wobei die Anzahl der Senken (3) gleich oder größer als zwei ist.

6. Vorrichtung zum Erkennen ungültiger Konfigurationen in einer bidirektionalen Multiplexing-Infrastruktur nach Anspruch 1, wobei eine Breite der gemultiplexten Datensignale unabhängig von dem Konfigurationsfehlerprüfer (14) ist und eine beliebige positive Zahl sein kann.

## Revendications

1. Appareil de détection de configurations invalides dans une infrastructure de multiplexage bidirectionnel, l'appareil comprenant l'infrastructure de multiplexage bidirectionnel, l'infrastructure de multiplexage bidirectionnel comprenant une logique de décodeur de multiplexeur (11), de multiples sources en tant qu'entrées (2) et de multiples collecteurs en tant que sorties (3), chaque source des multiples sources (2) correspondant à une source n (2), n désignant l'identifiant source, et les sources (2) et les collecteurs (3) étant connectés par l'intermédiaire de multiplexeurs vers l'avant (7) et vers l'arrière (8), **caractérisé en ce que** la logique de décodeur de multiplexeur (11) comprend en outre un vérificateur d'erreur de configuration (14) configuré pour détecter des configurations invalides et pour surveiller chaque source n (2) et tous les signaux de contrôle (10) des multiplexeurs vers l'arrière (8) connectés aux sources (2), le vérificateur d'erreur de configuration (14) comprenant une instance d'évaluation (15) pour chaque source n (2), chaque instance d'évaluation (15) étant configurée pour émettre un équivalent logique $E_n$ (25, 26) vers les signaux de contrôle (10) des multiplexeurs vers l'arrière (8) pour une source n (2), l'équivalent logique $E_n$ (25, 26) pour une source n (2) étant déterminé en connectant les signaux de contrôle des deux collecteurs à ladite source n (2) par une opération ET et par une opération OU par l'intermédiaire d'une porte ET et d'une porte OU, respectivement, le résultat de l'opération OU étant combiné à un signal de contrôle d'un collecteur supplémentaire pour ladite source n (2) par une opération ET supplémentaire et par une opération OU supplémentaire, cette étape de combinaison du résultat de l'opération OU avec un signal de contrôle d'un collecteur supplémentaire pour ladite source n (2) par une opération ET supplémentaire et par une opération OU supplémentaire est répétée jusqu'à ce que les signaux de contrôle de tous les collecteurs pour ladite source n (2) soient traités de cette manière et finalement que toutes les sorties des opérations ET traitées soient connectées par une opération OU finale par l'intermédiaire d'une porte OU finale, et la configuration invalide dans l'infrastructure de multiplexage bidirectionnel est détectée en fonction des informations d'erreur créées par le vérificateur d'erreur de configuration (14) indiquant quelle source n (2) est utilisée plus d'une fois.

2. Appareil de détection de configurations invalides dans une infrastructure de multiplexage bidirectionnel selon la revendication 1, si l'équivalent logique $E_n$ pour une source n (2) est zéro, alors une configuration de signal de contrôle pour ladite source n (2) est valide, autrement elle est invalide.

3. Appareil de détection de configurations invalides dans une infrastructure de multiplexage bidirectionnel selon l'une quelconque des revendications précédentes, si une somme E sur tous les équivalents logiques $E_n$ pour toutes les sources (2) est égale à zéro, la totalité de l'infrastructure de multiplexage bidirectionnel est valide, autrement elle est invalide.

4. Appareil de détection de configurations invalides dans une infrastructure de multiplexage bidirectionnel selon l'une quelconque des revendications précédentes, le nombre de sources (2) étant égal ou supérieur à deux.

5. Appareil de détection de configurations invalides dans une infrastructure de multiplexage bidirectionnel selon l'une quelconque des revendications précédentes, le nombre de collecteurs (3) étant égal ou supérieur à deux.

6. Appareil de détection de configurations invalides dans une infrastructure de multiplexage bidirectionnel selon la revendication 1, une largeur des signaux de données multiplexés étant indépendante du vérificateur d'erreur de configuration (14) et pouvant être n'importe quel nombre positif.

## FIG 1

Symbol

Switch-
Equivalent

## FIG 2

Multiplexer based on Standard Cells

FIG 3

FIG 4

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1426780 A2
- US 20040111657 A1